# EUROPEAN PATENT SPECIFICATION

(11) **EP 0 341 010 B1**
(45) Date of publication and mention of the grant of the patent: **17.08.1994**
(21) Application number: 89304375.2
(22) Date of filing: 02.05.1989
(51) Int. Cl.: C23C 14/06, C23C 16/06, C23C 16/22, C23C 28/00

(54) **Composite film**
Verbundschicht
Couche composée

(30) Priority: 02.05.1988 JP 109479/88; 02.05.1988 JP 109480/88
(43) Date of publication of application: 08.11.1989
(60) Divisional application: 92202490.6
(73) Proprietor: ORIENT WATCH CO., LTD., Tokyo (JP); Murayama, Youichi, Shinjyuku-ku, Tokyo (JP)
(72) Inventor: Murayama, Youichi, Shinjyuku-Ku, Tokyo (JP)
(74) Representative: Calamita, Roberto

(56) References cited:
- EP-A- 0 069 701
- GB-A- 2 083 842
- JAPANESE JOURNAL OF APPLIED PHYISICS (JJAP), PART 2, LETTERS, vol. 27, no. 4, April 1988, pages L687-L689, Tokyo, JP; T. MARO et al.: "CoCr-polyethylene Co-evaporated films"
- SOLAR ENERGY MATERIALS, vol. 15, no. 2, February 1987, pages 135-140, Elsevier Science Publishers B.V., Amsterdam, NL; L. MARTINU: "Electrical behaviour of composite plasma polymer/metal films"
- PATENT ABSTRACTS OF JAPAN, vol. 11, no. 3 (C-395)[2450], 7th January 1987; & JP-A-61 183 459

## Description

The present invention relates to a composite film. More particularly, the present invention relates to a composite film comprising a metal, an alloy and/or an inorganic substance with an organic substance. The film has excellent decorative, protective and functional properties.

A widely utilized procedure is the formation of a vapour-deposited thin film of a metal, an inorganic material or an organic polymer on the surface of a substrate comprising a metal, glass, ceramic material or plastics material, the thus-formed thin film being used as an insulating film, a reflecting film, an optical thin film, a display element or an electronic device. Known processes for depositing such a thin film on a substrate include vacuum vapour deposition, sputtering, ion plating, CVD, MOCVD, MBE, etc.

However, there are problems with these conventional methods. There are problems in preparing thin films having the desired properties and functions, and therefore the uses of thin films are at present limited.

One problem is that a conventional film which is excellent in colour tone, corrosion resistance, adhesion, wear resistance and other functional properties, and which is applicable as a useful surface material for watches and accessories has not as yet been achieved. Furthermore, in order to form such a film using a conventional method, it is necessary to prepare a layer comprising an expensive metal or an alloy thereof, thus resulting in difficulty in preparing a composite film excellent in decorative property, protection and functionality and which may be manufactured at a low cost.

Japanese Journal of Applied Physics, Part 2, Letters, Vol. 27, No. 4, April 1988, pp L687-L689 describes electron beam deposition of CrCo and polyethylene. EP-A-69701 describes plasma deposition of MoS₂ and PTFE, and Solar Energy Materials, Vol. 15, No. 2, February 1987, pp. 135-140, Elsevier Science Publishers, B.V. Amsterdam, Netherlands discloses plasma polymerisation of C₂F₃Cl and magnetron sputtering of Au. None of these documents addresses the problems mentioned above.

To address these problems, in one aspect the present invention provides a film layer comprising an organic substance selected from one or more of polycarbonates, polyacrylates, polysiloxanes, polyesters and polyolefins and
either (A) one or more metals selected from Au, Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb and In, or an alloy of two or more of said metals;
and/or (B) an inorganic substance selected from TiN, TaN, ZrN, TaC, VN and C,
said organic substance having been co-deposited by simultaneous vapour phase co-deposition thereof or from a corresponding monomer vapour with said component (A) and/or said component (B),
with the proviso that when said component (A) is CrCo said organic substance is not polyethylene and that when said component (A) is Au said organic substance is not trifluorochloroethylene.

In another aspect the present invention provides a multilayered film comprising the above film as one layer thereof. The film is preferably deposited by plasma exciting vapour phase deposition.

As the metal or the alloy in the film of the present invention, gold and/or at least one metal selected from Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb and In or an alloy thereof may be used. As the inorganic substance, TiN, TaN, ZrN, TaC, VN and/or C may be employed.

Applicable organic substances are polycarbonate, polyacrylate, polysiloxane, polyester, polyolefin, and polyethylene.

Depending upon the material of the substrate on which the film is to be formed, an undercoat comprising a metal, an alloy, an inorganic substance and/or an organic substance may be formed on the surface of the substrate, and further a composite film may be stacked thereon integrally therewith.

It is also possible to arrange a film as described above on the surface of a substrate, and stack an outer coat comprising a metal, an alloy, an inorganic substance and/or an organic substance thereon integrally therewith.

Furthermore, it is possible to form an undercoat comprising a metal, an alloy, an inorganic substance and/or an organic substance on the surface of a substrate, stack a composite compound film thereon, and form an outer coat comprising a metal, an alloy, an inorganic substance and/or an organic substance thereon integrally therewith.

Methods applicable for forming such a film include a technique of evaporating a metal, an alloy, and/or an inorganic substance and an organic substance, simultaneously exciting the evaporated particles, and causing vapour-deposition in the state of ionized particles, neutral particles or radicals, and a method of sputtering, without excitation, etc. In terms of colour tone and adhesion strength, it is desirable to integrally form the film in the excited state.

In this case, evaporated particles should preferably be excited in a vacuum reactor by glow discharge and be plasma-ionized particles. The methods applicable for plasma-ionization include ion-plating processes such as the hollow cathode method and high-frequency excitation, and plasma CVD. For an organic substance, it is also possible to use the method of polymer evaporation or introduction of monomer gas and vapour-depositing it through plasma polymerization.

For excitation, light radiation such as a laser beam may be applied. In using the ion-plating method, an inert gas such as argon may be introduced into a vacuum reactor, for example, maintained in a vacuum at a pressure of from 10⁻² to 10⁻⁵ Torr (1.33 to 1.33 x 10⁻³ Pa). The temperature of the substrate may be within the range of from room temperature to about 400°C. A reactive gas such as oxygen, nitrogen, ammonia, hydrogen carbide, hydrogen sulfide, or hydrogen fluoride may be introduced for vapour deposition by reactive ion-plating. In this case, the gas pressure should preferably be at least 10⁻⁴ Torr (1.33 x 10⁻² Pa).

By the present invention, as described above, it is possible to achieve a film or multilayer film excellent in colour tone, having a satisfactory adhesion strength and having such functional properties as dielectric property, conductivity and light response.

In the present invention, the multilayered film may, for example, be formed by vapour-depositing an organic polymer film on the surface of a substrate comprising a metal, an alloy, ceramics or plastics, and then sequentially forming a thin film comprising a metal, an alloy and/or an inorganic substance, and an organic polymer layer, or formed by vapour-phase depositing a thin film comprising a metal, an alloy and/or an inorganic substance, then an organic polymer film, and subsequently, a thin film comprising a metal, an alloy and/or an inorganic substance.

The thin film comprising a metal, an alloy and/or an inorganic substance in the present invention may, for example, be gold, a gold alloy or TiN, and not limited to these examples, a metal, an alloy or an inorganic substance having the desired colour tone and gloss. Examples of the metal or the alloy used in the present invention include such elements as gold, Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb and In or an inorganic substance comprising a compound thereof such as TiN, TaN, ZrN, TaC, VN and/or C.

An organic polymer may also be present as a separate film which may be a thin film comprising a polymer such as polycarbonate, polyacrylate, polysiloxane, polyester, polyolefin, or polyethylene. In this case, a dye compound or a pigment could be vapour-deposited for colouring.

There is no particular limitation for the substrate, which may be a glass, a metal, an alloy, a ceramic material or a plastics material.

The thin film comprising a metal, an alloy and/or an inorganic substance and the organic polymer film as listed above may be formed by plasma-exciting particles produced through evaporation of the material and vapour-depositing the resultant ionized particles, neutral particles or radicals. It is also possible to form a thin film of metal or alloy, not by excitation, but by sputtering, etc. However, with a view to largely improving the colour tone, adhesion strength and wear resistance of the composite multilayered film, it is desirable to integrally form it by plasma excitation.

The evaporated particles should preferably be excited by glow discharge in a vacuum reactor for plasma ionization. Means for plasma ionization convenient in this case include ion plating such as the hollow cathode method and the high-frequency excitation method, and plasma CVD. When forming the organic polymer film, plasma excitation may be applied by evaporating the polymer or introducing a monomer gas for vapour deposition. Laser beam excitation may also be applied.

When applying the ion plating method, an inert gas such as argon could be introduced into a vacuum reactor kept in vacuum at a pressure of, for example, from 10⁻² to 10⁻⁵ Torr. (1.33 to 1.33 x 10⁻³ Pa) The substrate temperature may be within the range of from room temperature to about 400°C. When forming an inorganic thin film, vapour deposition could be preferably carried out by ion plating through introduction of a reactive gas such as oxygen, nitrogen, ammonia, hydrogen carbide, hydrogen sulfide, or hydrogen fluoride. In this case, the gas pressure should preferably be at least 10-⁴ Torr. (1.33 x 10⁻² Pa)

By the present invention, as described above, it is possible to achieve a low-cost film excellent in colour tone, having a satisfactory adhesion strength, and having such functional properties as dielectric property, conductivity and light response.

The present invention will now be illustrated by means of the following non-limiting Examples.

In the following examples reference will be made to the accompanying drawings in which:
Fig. 1 is a partial sectional view illustrating an embodiment of a multilayered film of the present invention, in which a gold composite compound film is vapour-deposited on a substrate having a previously deposited TiN layer;
Fig. 2 is a partial sectional view illustrating an embodiment of the present invention, in which an undercoat is made on TiN layer deposited on a substrate, and a gold-containing film is formed on the undercoat;
Fig. 3 is a partial sectional view illustrating an embodiment of the present invention, in which a gold-containing film is formed on a TiN layer stacked on a substrate, and an outer coat is vapour-deposited thereon;
Fig. 4 is a partial sectional view illustrating an embodiment where an undercoat is made on a TiN layer deposited on a substrate, a gold-containing film being formed thereon, and a top coat is vapour-deposited further thereon;
Fig. 5 is a partial sectional view illustrating an embodiment where a transparent conductive film is formed on the surface of the multilayered film shown in Fig. 3;
Fig. 6 is a partial sectional view illustrating a case where a film is formed on the multilayered film shown in Fig. 3, and
Figs. 7 and 8 are sectional views illustrating typical multilayered films of the present invention.

### Example 1

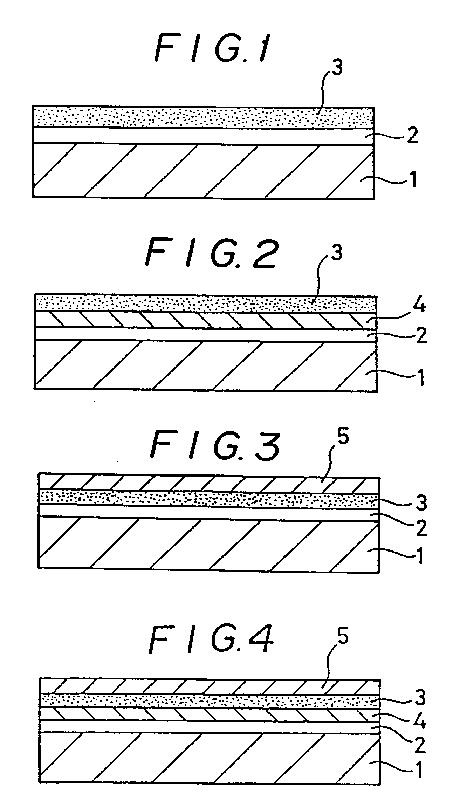

A film was formed using an ion plating apparatus based on the high-frequency excitation method. Figure 1 illustrates this example. A stainless steel sheet was used as the substrate (1). The stainless steel sheet was bombarded by introducing argon gas under a pressure of 5 x 10⁻³ Torr (0.67 Pa), and then a TiN thin film (2) was vapour-deposited by reactive ion plating with nitrogen gas and evaporated Ti particles under a pressure of 8 x 10⁻⁴ Torr (0.11 Pa). A TiN thin film (2) having a thickness of 0.2 micrometres was formed by reaction for three minutes under conditions including a discharge power of 300 W and a substrate temperature of 100°C.

Then, under an argon pressure of 4 x 10⁻³ Torr (0.53 Pa), evaporated particles of gold and polycarbonate were plasma-ionized to form a film (3) on the surface of the TiN thin film (2) on the substrate (1). As a result, a film (3) having a colour tone equal to that of gold was obtained, with a wear resistance about twice as high as that available in vapour deposition of gold on the substrate. As to adhesion strength, no peel off was observed in a bend test of 90°, and an excellent corrosion resistance was shown.

### Example 2

In a manner similar to that in Example 1, a substrate (1) having a titanium nitride thin film (2) formed thereon was used, as shown in Fig. 2, and under an argon pressure of 4 x 10⁻³ Torr (0.53 Pa), evaporated polycarbonate particles were plasma-ionized on to the titanium nitride thin film. Thus, an undercoat (4) (with regard to the ultimate outer layer) was formed by vapour-depositing a polymer film (polycarbonate) on the substrate.

Subsequently, gold-chromium alloy (with a chromium content of 2%) was evaporated together with polycarbonate to form a film (3) of polycarbonate and gold chromium alloy with a thickness of about 0.2 micrometres on the polycarbonate polymerization film.

The thus-formed film has a colour tone identical with that of gold-chromium alloy, with such an excellent adhesion that no separation was observed in a 90° bend test, as well as high wear resistance and corrosion resistance.

### Example 3

As shown in Fig. 3, a polycarbonate polymer film was vapour-deposited as the top coat (5) under an argon pressure of 4 x 10⁻³ Torr (0.53 Pa) on the surface of the film (3) obtained in Example 1. As a result, a hard transparent polymer film was obtained. This multilayered film had a colour tone identical with that of gold, with a gloss, and showed an elegant appearance. This transparent polymer film was excellent in protection of the film, as well as in adhesion, wear resistance and corrosion resistance as in Example 1.

### Example 4

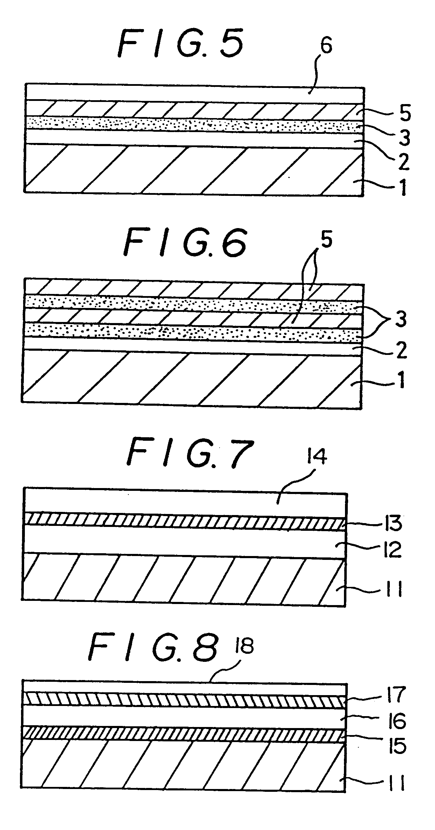

As in Example 1, a substrate (1) having a titanium nitride thin film (2) formed thereon was used as shown in Fig. 4 and under an argon pressure of 4 x 10⁻³ Torr (0.53 Pa), evaporated polycarbonate particles were plasma-ionised. Thus, a polymer film was vapour-deposited as the undercoat (4) on the substrate.

Then, gold chromium alloy ( with a chromium content of 2%) was evaporated together with polycarbonate to form a film (3) of polycarbonate and gold-chromium alloy having a thickness of about 0.2 micrometres on the polycarbonate polymer film.

Subseqently, evaporation of gold-chromium alloy was discontinued, and a polymer film comprising polycarbonate alone having a thickness of about 0.2 micrometre was formed as the top coat (5) by vapour deposition on the film.

The thus-formed film had colour tone identical with that of gold-chromium alloy, with such an excellent adhesion that no separation was observed in a 90° bend test, as well as high wear resistance and corrosion resistance.

### Example 5

As shown in Fig. 5, a 0.3 micrometre-thick ITO (transparent conductive substance) film (6) was formed on the surface of the multilayered film obtained in Example 3, with ITO as the evaporation source under conditions including an oxygen gas pressure of 3 x 10⁻⁴ Torr (0.04 Pa), a discharge power of 300 W and a substrate temperature including the film (3) of Example 4 of 200°C. The thus-obtained multilayered film had a colour tone of gold and a gloss, resulting in an elegant appearance. Protection provided by the film was further improved, with excellent adhesion, wear resistance and corrosion resistance as in Example 1, and had a surface conductivity (resistance: 200 Ω/□).

### Example 6

A film was formed using a high frequency sputtering apparatus. A stainless steel sheet was used as the substrate. After pre-sputtering for about 15 minutes by introducing argon gas under a pressure of 5 x 10⁻³ Torr (0.67 Pa), nitrogen gas was introduced under a pressure of 5 x 10⁻⁴ Torr (0.067 Pa) using TiN as the target. Then, argon was introduced up to a pressure of 2 x 10⁻² Torr (2.7 Pa), and sputtering was conducted for two hours by applying a high-frequency power of 10 W/cm² to form a TiN film having a thickness of about 0.5 micrometre. Subsequently, the target was replaced with Au (containing 1% Cr), and sputtering was conducted for about 10 minutes with a high-frequency power of 2 W/cm² by introducing ethylene (C₂H₄) up to 1 x 10⁻⁴ Torr (0.013 Pa) and adding argon gas up to 5 x 10⁻³ Torr (0.067 Pa). A film comprising gold-chromium alloy and ethylene was thus obtained, having a gold colour tone, and being excellent both in adhesion and corrosion resistance.

### Example 7

A multilayered film was formed using a high-frequency ion plating apparatus. A nickel-plated brass sheet was used as the substrate. After introducing argon gas up to 5 x 10⁻⁴ Torr (0.067 Pa), ion bombardment was conducted at a high-frequency power of 500 W and a DC electric field of -200V for about 15 minutes. Then, titanium was evaporated using an electron gun, by introducing argon gas up to 8 x 10⁻⁴ Torr (0.11 Pa), under discharge conditions including a high-frequency power of 500W, and a DC electric field of -200V, to form a TiN film having a thickness of about 1 micrometre in 30 minutes. Subsequently, the substrate was transferred to a high frequency sputtering apparatus, in which sputtering was conducted for about 10 minutes, with Au (containing 1% Cr) as the target, by introducing ethylene (C₂H₄) up
to 1 x 10⁻⁴ Torr (0.013 Pa) and adding argon gas up to 5 x 10⁻³ Torr (0.67 Pa) with a high-frequency power of 2W/cm² to obtain a film comprising gold-chromium alloy and ethylene. The resultant film had a gold colour tone and was excellent both in adhesion and in corrosion resistance.

### Example 8

A film was formed using a high-frequency sputtering apparatus. A nickel-plated brass sheet was used as the substrate. After sputtering for about 15 minutes by introducing argon gas up to 5 x 10⁻³ Torr (0.67 Pa), nitrogen gas at 5 x 10⁻⁴ Torr (0.067 Pa) was introduced, with a TiN target, and then, sputtering was carried out for two hours with a high-frequency power of 10W/cm² by introducing argon up to 2 x 10⁻² Torr (2.67 Pa) to form a TiN film having a thickness of about 0.5 micrometre. Subsequently, the substrate was transferred to an ion plating apparatus, in which gold (containing 1% Cr) was evaporated in a resistance-heating type boat under discharge with a high-frequency power of 40 W by introducing ethylene gas to 4 x 10⁻⁴ Torr (0.053 Pa), and a film comprising gold-chromium alloy and ethylene having a thickness of about 1 micrometre was formed in 10 minutes. The formed film was excellent in adhesion, wear resistance and corrosion resistance.

### Example 9

A film was formed by a high-frequency ion plating-apparatus. A glass plate (Corning 7059) was used as the substrate. After ion bombardment conducted for 15 minutes under conditions including a high-frequency power of 300 W and a DC electric field of -200V by introducing argon gas up to 5 x 10⁻⁴ Torr (0.067 Pa), butadiene gas was introduced up to 5 x 10⁻⁴ Torr (0.067 Pa), and a 1,000Å (0.1 micrometre) film was formed in about 10 minutes by evaporating germanium in a resistance-heating type boat under discharge of high-frequency power of 50 W. This film showed negative resistance-temperature characteristics and a specific resistance of from 10⁻⁴ to 10⁻⁵ Ωcm.

### Example 10

A film was formed using a high-frequency ion plating apparatus. A glass plate (Corning 7059) was used as the substrate. After ion bombardment conducted for 15 minutes under conditions including a high-frequency power of 300W and a DC electric field of -200V by introducing argon gas up to 5 x 10⁻⁴ Torr (0.067 Pa), ethylene gas was introduced up to 5 x 10⁻⁴ Torr (0.067 Pa), and a 2,000Å (0.2 micrometre) film was formed in about 10 minutes by evaporating In (Indium) in a resistance-heating type heat under discharge of a high-frequency power of 50 W. This film was transparent and showed negative resistance-temperature characteristics.

### Example 11

A film was formed using a high-frequency ion plating apparatus. An aluminium plate was used as the substrate. After ion bombardment conducted for 15 minutes under conditions including a high-frequency power of 300 W and a DC electric field of -200 V by introducing argon gas up to 5 x 10⁻⁴ Torr (0.067 Pa), ethylene gas was introduced up to 5 x 10⁻⁴ Torr (0.067 Pa), and a 200 Å (0.02 micrometre) film of Ni-Cr alloy and ethylene was formed in about 10 minutes by evaporating an Ni-Cr alloy in a resistance-heating type boat under discharge of a high-frequency power of 50 W. This film had a temperature coefficient of about ± 10 ppm/°C, and a high specific resistance of 500 µΩcm, thus permitting use as a high resistance element. As described above in detail, the present invention provides the following industrially useful effects by comprising forming a film on a substrate through vapour-phase deposition of a metal, an alloy
and/or an inorganic substance and an organic substance, and simultaneously using as required a top coat, an undercoat, or a top coat and an undercoat;
1. It is possible to reduce the consumption of the metal, alloy or inorganic substance without changing the colour tone of the metal, the alloy or the inorganic substance used.
2. The film having an organic substance can have a frictional coefficient lower than that of a film formed from a metal, an alloy or an inorganic substance alone, and wear resistance can be improved over that of a film comprising only the material of the film.
3. In a film formed from a metal, an alloy or an inorganic substance alone, corrosion resistance may be affected by the occurrence of pinholes. In the film, in contrast, corrosion resistance can be largely improved.
4. The film as applied to an article in direct touch with human skin gives a lower sensation of coldness than when human skin touches a metal, an alloy or an inorganic substance. Moreover the film can prevent allergy to Ni ions, etc.
5. It is possible to provide the surface a film with conductivity, so that conductive films of various colour tones can be prepared.

These merits are particularly effective when applying the present invention to an accessory, a watch, glasses and other articles of utility, thus providing a very wide range of applications including display elements using various colour tones as part of the design thereof.

## Claims

1. A film layer comprising an organic substance selected from one or more of polycarbonates,
polyacrylates, polysiloxanes, polyesters and polyolefins and
either (A) one or more metals selected from Au, Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb and In, or an alloy of two or more of said metals;
and/or (B) an inorganic substance selected from TiN, TaN, ZrN, TaC, VN and C,
said organic substance having been co-deposited by simultaneous vapour phase co-deposition thereof or from a corresponding monomer vapour with said component (A) and/or said component (B),
with the proviso that when said component (A) is CrCo said organic substance is not polyethylene and that when said component (A) is Au said organic substance is not trifluorochloroethylene.

2. A film layer as claimed in claim 1 wherein said organic substance is a polycarbonate.

3. A film layer as claimed in claim 1 wherein said organic substance is a polyolefin.

4. A film layer as claimed in claim 3 wherein said polyolefin is polyethylene.

5. A film layer as claimed in any one of the preceding claims wherein said component (A) is Au.

6. A film layer as claimed in any one of the preceding claims wherein said component (B) is TiN.

7. A multilayered film having at least 2 layers, which comprises as one layer thereof a film layer as claimed in claim 1.

8. A multilayered film as claimed in claim 7 comprising as one layer thereof an undercoat layer (2) comprising a metal, an alloy, an inorganic substance and/or an organic substance, said undercoat layer (2) having been formed on the surface of a substrate (1), said film (3) as claimed in claim 1 having been formed on said undercoat layer integrally therewith, said metal, alloy, inorganic substance and organic substance being defined as in claim 1.

9. A multilayered film as claimed in claim 7 including a film as claimed in claim 1 which has been formed on the surface of a substrate (1), and an outer coat (5) comprising a metal, an alloy, an inorganic substance, and/or an organic substance which has been formed on the film integrally therewith, said metal, alloy, inorganic substance and organic substance being defined as in claim 1.

10. A multilayered film as claimed in claim 7 comprising an undercoat layer (2) comprising a metal, an alloy, an inorganic substance and/or an organic substance, said undercoat layer (2) having been formed on the surface of a substrate (1), a film as claimed in claim 1 which has been formed on the undercoat layer (2) and an outer coat (3) comprising a metal, an alloy, an inorganic substance, and/or an organic substance which has been formed on the film integrally therewith, said metal, alloy, inorganic substance and organic substance being defined as in claim 1.

11. A multilayered film as claimed in claim 7 comprising a multilayered film (6) having surface conductivity formed on the surface of a
film as claimed in claim 1 or on the surface of a multilayered film as claimed in any one of claims 7 to 10.

12. An article coatedwith a film as claimed in any one of the preceding claims.

13. A method of coating a surface which comprises forming a film thereon by depositing on said surface a metal, an alloy and/or an inorganic substance with an organic substance by simultaneous vapour-phase co-deposition, said metal, alloy, inorganic substance and organic substance being defined as in claim 1.

14. A method of coating a surface which comprises forming at least two coating layers on said surface, at least one of these layers being a film as claimed in claim 1.

## Patentansprüche

1. Überzugsschicht, die eine organische Substanz umfaßt, ausgewählt unter einer oder mehreren von Polycarbonaten, Polyacrylaten, Polysiloxanen, Polyestern und Polyolefinen und entweder (A) einem oder mehreren Metallen, ausgewählt unter Au, Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb und In oder einer Legierung von zwei oder mehreren dieser Metalle; und/oder
(B) einer anorganischen Substanz, ausgewählt unter TiN, TaN, ZrN, TaC, VN und C,
wobei die organische Substanz durch gleichzeitige Dampfphasen-Co-Abscheidung daraus oder aus einem entsprechenden Monomer-Dampf mit der Komponente (A) und/oder der Komponente (B) zusammen abgeschieden wird,
mit der Maßgabe, daß, wenn die Komponente (A) CrCo ist, die organische Substanz nicht Polyethylen ist, und daß, wenn die Komponente (A) Au ist, die organische Substanz nicht Trifluorchlorethylen ist.

2. Überzugsschicht nach Anspruch 1, worin die organische Substanz ein Polycarbonat ist.

3. Überzugsschicht nach Anspruch 1, worin die organische Substanz ein Polyolefin ist.

4. Überzugsschicht nach Anspruch 3, worin das Polyolefin Polyethylen ist.

5. Überzugsschicht nach einem der vorangegangenen Ansprüche, worin die Komponente (A) Au ist.

6. Überzugsschicht nach einem der vorangegangenen Ansprüche, worin die Komponente (B) TiN ist.

7. Mehrfachschicht mit wenigstens zwei Schichten, die als eine Schicht davon eine Überzugsschicht nach Anspruch 1 umfaßt.

8. Mehrfachschicht nach Anspruch 7, die als eine Schicht davon eine Unterschicht (2) umfaßt, die ein Metall, eine Legierung, eine anorganische Substanz und/oder eine organische Substanz umfaßt, wobei die Unterschicht (2) auf der Oberfläche eines Substrates (1) gebildet wird, wobei die Überzugsschicht (3), wie sie in Anspruch 1 beansprucht wird, auf dieser Unterschicht integriert damit gebildet wird, wobei das Metall, die Legierung, die anorganische Substanz und die organische Substanz wie in Anspruch 1 definiert sind.

9. Mehrfachschicht nach Anspruch 7, die eine Überzugsschicht, wie in Anspruch 1 definiert, einschließt, die auf der Oberfläche eines Substrates (1) gebildet wird, und einen äußeren Überzug (5), umfassend ein Metall, eine Legierung, eine anorganische Substanz und/oder eine organische Substanz, der auf der Überzugsschicht integriert damit gebildet wird, wobei das Metall, die Legierung, die anorganische Substanz und die organische Substanz wie in Anspruch 1 definiert sind.

10. Mehrfachschicht nach Anspruch 7, umfassend
eine Unterschicht (2), die ein Metall, eine Legierung, eine anorganische Substanz und/oder eine organische Substanz umfaßt, wobei die Unterschicht (2) auf der Oberfläche eines Substrates (1) gebildet wird,
eine Überzugsschicht wie in Anspruch 1 beansprucht, die auf der Unterschicht (2) gebildet wird,
und eine äußere Schicht (3), umfassend ein Metall, eine Legierung, eine anorganische Substanz und/oder eine organische Substanz, die auf der Überzugsschicht integriert damit gebildet wird, wobei das Metall, die Legierung, die anorganische Substanz und die organische Substanz wie in Anspruch 1 definiert sind.

11. Mehrfachschicht nach Anspruch 7, die eine Mehrfachschicht (6) mit Oberflächenleitfähigkeit umfaßt, gebildet auf der Oberfläche einer Überzugsschicht, wie in Anspruch 1 beansprucht, oder auf der Oberfläche einer Mehrfachschicht, wie in einem der Ansprüche 7 bis 10 beansprucht.

12. Gegenstand, der mit einer Schicht überzogen ist, wie sie in einem der vorangegangenen Ansprüche beansprucht wird.

13. Verfahren zum Überziehen einer Oberfläche, gekennzeichnet durch Bildung einer Schicht darauf durch Abscheidung eines Metalles, einer Legierung und/oder einer anorganischen Substanz mit einer organischen Substanz auf der Oberfläche durch gleichzeitige Dampfphasen-Co-Abscheidung, wobei das Metall, die Legierung, die anorganische Substanz und die organische Substanz wie in Anspruch 1 definiert sind.

14. Verfahren zum Überziehen einer Oberfläche, gekennzeichnet durch Bildung von wenigstens zwei Überzugsschichten auf der Oberfläche, wobei wenigstens eine dieser Schichten eine Überzugsschicht ist, wie sie in Anspruch 1 beansprucht wird.

## Revendications

1. Couche mince comprenant une substance organique choisie parmi l'un ou plusieurs des polycarbonates, polyacrylates, polysiloxanes, polyesters et polyoléfines, avec
(A) un ou plusieurs métaux choisis parmi Au, Cu, Al, Ni, Ag, Zn, Sn, Ta, V, Cr, Co, Pt, Pd, Ru, Rh, Ti, W, Mo, Ir, Cd, Sb, Hf, Ga, Si, Fe, Y, Ba, Ge, Zr, Nb et In, ou un alliage de deux ou plusieurs desdits métaux ; et/ou
(B) une substance minérale choisie parmi TiN, TaN, ZrN, TaC, VN et C,
ladite substance organique ayant été co-déposée avec ledit composant (A) et/ou ledit composant (B) par dépôt simultané en phase vapeur d'elle-même ou à partir d'une vapeur de monomère correspondant,
avec les conditions que si ledit composant (A) est CrCo, ladite substance organique ne soit pas du polyéthylène, et que si ledit composant (A) est Au, ladite substance organique ne soit pas le trifluorochloroéthylène.

2. Couche mince telle que revendiquée dans la revendication 1, dans laquelle ladite substance organique est un polycarbonate.

3. Couche mince telle que revendiquée dans la revendication 1, dans laquelle ladite substance organique est une polyoléfine.

4. Couche mince telle que revendiquée dans la revendication 3, dans laquelle ladite polyoléfine est du polyéthylène.

5. Couche mince telle que revendiquée dans l'une quelconque des revendications précédentes, dans laquelle ledit composant (A) est Au.

6. Couche mince telle que revendiquée dans l'une quelconque des revendications précédentes, dans laquelle ledit composant (B) est TiN.

7. Couche multiple ayant au moins 2 couches, dont une couche au moins est une couche mince telle que revendiquée dans la revendication 1.

8. Couche multiple telle que revendiquée dans la revendication 7, dont une couche est une sous-couche (2) comprenant un métal, un alliage, une substance minérale et/ou une substance organique, ladite sous-couche (2) ayant été formée sur la surface d'un substrat (1), ladite couche mince (3) telle que revendiquée dans la revendication 1 ayant été formée sur ladite sous-couche solidairement à celle-ci, ledit métal, ledit alliage, ladite substance minérale et ladite substance organique étant tels que définis dans la revendication 7.

9. Couche multiple telle que revendiquée dans la revendication 7, comprenant une couche mince telle que revendiquée dans la revendication 1 qui a été formée sur la surface d'un substrat (1), et une couche extérieure (5) comprenant un métal, un alliage, une substance minérale et/ou une substance organique qui a été formée sur la couche mince solidairement à celle-ci, ledit métal, ledit alliage, ladite substance minérale et ladite substance organique étant tels que définis dans la revendication 1.

10. Couche multiple telle que revendiquée dans la revendication 7, comprenant une sous-couche (2) comprenant un métal, un alliage, une substance minérale et/ou une substance organique, ladite sous-couche (2) ayant été formée sur la surface d'un substrat (1), une couche mince telle que revendiquée dans la revendication 1 qui a été formée sur la sous-couche (2) et une couche extérieure (3) comprenant un métal, un alliage, une substance minérale et/ou une substance organique qui a été formée sur la couche mince solidairement à celle-ci, ledit métal, ledit alliage, ladite substance minérale et ladite substance organique étant tels que définis dans la revendication 1.

11. Couche multiple telle que revendiquée dans la revendication 7, comprenant une couche multiple (6) douée de conductivité superficielle formée sur la surface d'une couche mince telle que revendiquée dans la revendication 1 ou sur la surface d une couche multiple telle que revendiquée dans l'une quelconque des revendications 7 à 10.

12. Article revêtu d'une couche telle que revendiquée dans l'une quelconque des revendications précédentes.

13. Procédé de revêtement d'une surface, qui consiste à y former une couche en déposant sur ladite surface un métal, un alliage et/ou une substance minérale avec une substance organique par co-dépôt simultané en phase vapeur, ledit métal, ledit alliage, ladite substance minérale et ladite substance organique étant tels que définis dans la revendication 1.

14. Procédé de revêtement d'une surface, qui comprend la formation d'au moins deux couches de revêtement sur ladite surface, l'une au moins de ces couches étant une couche mince telle que revendiquée dans la revendication 1.
